# EUROPEAN PATENT SPECIFICATION

(11) **EP 3 540 451 B1**
(45) Date of publication and mention of the grant of the patent: **01.04.2020**
(21) Application number: 18305272.9
(22) Date of filing: 14.03.2018
(51) Int. Cl.: G01R 31/327, G01R 15/14

(54) **VOLTAGE SENSING**
SPANNUNGSERFASSUNG
DÉTECTION DE TENSION

(43) Date of publication of application: 18.09.2019
(73) Proprietor: Mitsubishi Electric R&D Centre Europe B.V., 1119 NS Schiphol Rijk Amsterdam (NL); Mitsubishi Electric Corporation, Tokyo 100-8310 (JP)
(72) Inventor: DEGRENNE, Nicolas, 35708 RENNES cedex 7 (FR)
(74) Representative: Plasseraud IP

(56) References cited:
- WO-A1-2005/109600
- US-A1- 2015 006 095
- US-B2- 9 575 096

## Description

The invention pertains to the technical field of power semiconductor devices. More specifically, the invention is related to the monitoring of such devices. WO 2005/109600 measures battery cell voltages using a flying capacitor. Other art is known from US9575096 and US2015/006095.

Monitoring voltages in power semi-conductor devices is an important function. For example, it is useful for fault detection, health monitoring, current sensing and temperature sensing. Voltage can be monitored across such devices themselves and/or there connections, for example a collector-emitter on-state voltage drop, a gate voltage or a voltage drop across a gate resistance. The monitored voltages enable, for example, to deduce the on-state voltage differences between the collector and emitter for an Insulated Gate Bipolar Transistor (IGBT), between anode and cathode for a diode assembly, or between drain and source for a Metal-Oxide-Semiconductor Field-Effect Transistor (MOSFET).

Usually the voltages are comprised between 0.1V and 5V depending on the type of devices, the temperature and the current through it. A first difficulty is to measure this voltage with high accuracy, high precision, low drift and high stability. These constraints lead generally to use high-cost sensors.

The differential signal of interest is subject to high common-mode perturbation. For example, the emitter voltage can be hundreds or thousands of volts above the reference voltage of the main acquisition system. The high voltage difference imposes the use of electrical isolation equipment to preserve the measurement circuit. Such equipment must withstand high and quick variations of voltages (up to tens of Volts by nanoseconds) during switch commutations. These constraints thus lead to high clamping and isolation requirements (high voltage, low parasitic capacitance) leading to an additional cost for modules comprising semiconductor devices.

The invention improves the situation.

It is proposed a power semi-conductor module comprising:
- an high-voltage part arranged to operate at high-voltage and including a power semi-conductor switch;
- an acquisition part arranged to acquire measures from the high-voltage part and to operate at a low voltage incompatible with said high-voltage;
- an intermediate circuit, electrically disposed between the high-voltage part and the acquisition part; and
- a control part.
The said intermediate circuit has the at least two following states:
- a sample state wherein said intermediate circuit is electrically disconnected from the acquisition part and electrically connected to the high-voltage part such that a voltage sample of the operating high-voltage is stored on said intermediate circuit;
- an acquiring state wherein said intermediate circuit is electrically disconnected from the high-voltage part and electrically connected to the acquisition part such that a voltage sample previously stored on said intermediate circuit is discharged to the acquisition part.
The control part is arranged to control the states changing of the intermediate circuit.

Such a module enables to ensure equivalent functions of known semi-conductor modules with less clamping components, less isolations components and less Analog-to-Digital Converters (ADC). For example, in a module including a plurality of semi-conductor devices, a common clamping circuit and a common ADC can be used in place of a plurality of each. As a consequence, such modules are less bulky, simpler and cheaper than the known modules. By reducing the number of components, the risk off malfunctioning is also reduced.

In another aspect, it is proposed a method for sensing a voltage of at least one power semi-conductor switch into a module including one or more power semi-conductor switches. The method comprises:
a) detect an on-state of at least one of said power semi-conductor switches;
b) after said on-state detection, sample and hold a voltage of at least one of said power semi-conductor switches;
c) detect an off-state of at least one of said power semi-conductor switches;
d) after said off-state detection, transmit said hold voltage to an acquisition part of said module.

The module and/or the method can optionally comprise the following features, separately or in combination one with the others:
- The module is deprived from analog isolator and digital isolator between said high-voltage part and said acquisition part. This enables to reduce the size and the cost of the module.
- The module comprises at least two high-voltage parts arranged to operate at high-voltage, said acquisition part being arranged to acquire measures from both high-voltage parts. This enables to reduce the number of components.
- The acquisition part includes at least two input channels such that to acquire two distinct voltages measures. This enables to monitor a plurality of voltages and to deduce other ones by post-treatment of the measures.
- The intermediate circuit includes at least one capacitance electrically disposed between the two switches, or a sample-and-hold circuit, each switch being controlled by said control part, the states of the switches defining said sample state and acquiring state of the module. This enables to adapt the monitoring at will.
- The module further comprises at least one clamp circuit electrically disposed between said high-voltage part and said intermediate circuit, and/or between said intermediate circuit and said acquisition part. This enables to acquire measures from a part of the module while protecting the acquisition part from high voltage from other parts of the module.
- The control part is arranged in such a way to command said intermediate circuit at least in function of a state of said high-voltage part. This enables to adapt the monitoring to the real operational behavior of the active parts and to obtain measures in near real-time.
- The control part is arranged to provide a delaying time function such that emission of output control signals can be delayed with respect to reception of input information signals. This enables to ensure the protection of the acquisition part of the module, including during very sensitive transient period like switching instant during which voltage drops can occur.
- The method for sensing a voltage further comprises the following step after said step a) and before said step b):
   a') delaying the implementation of said step b) during a predetermined buffer time. This enables to ensure an important reducing of measured noises.
- The step c) of detecting an off-state of at least one of said power semi-conductor switches of the method includes detecting an on-state of another one of said power semi-conductor switches of said module such that the off-state detection is indirect. This enables to reduce the number of components by attributing at least two functions to common components.
- The method further comprises:
   e) after said off-state detection of said step c), acquiring a voltage by said acquisition part of said module of at least one of said power semi-conductor switches distinct from the power semi-conductor switch of which the voltage has been sampled and hold in step b). This enables to acquire the voltage of at least two power semi-conductor switches of the module.

Other features, details and advantages will be shown in the following detailed description and on the figures, on which:
- Figures 1 and 2 show an embodiment of the invention in two distinct states;
- Figures 3 and 4 show an embodiment of the invention in two distinct states;
- Figure 5 is a set of graphics representing evolutions of voltages between the two states of the embodiment shown on figure 3 and 4; and
- Figures 6 to 10 each shows an electrical circuitry corresponding to an embodiment of the invention.

Figures and the following detailed description contain, essentially, some exact elements. They can be used to enhance understanding the invention and, also, to define the invention if necessary.

Figures show various embodiments of a power semi-conductor module 1 either in a sample state referenced "A" or in an acquiring state referenced "B". Each module comprises:
- at least one high-voltage part;
- at least one acquisition part;
- at least one intermediate circuit; and
- at least one control part.

Each high-voltage part comprises at least one semi-conductor switch, for example an Insulated Gate Bipolar Transistor (IGBT), a Metal-Oxide-Semiconductor Field-Effect Transistor (MOSFET) and/or a diode assembly. Each high-voltage part is arranged to operate at high-voltage and high-voltage drops. By "high voltage", it has to be understood that the normal operating voltages of the high-voltage part is not compatible with the normal operating "low voltage" of the acquisition part. In other words, if the acquisition part is submitted to such an high voltage drop, a serious risk of degradation or destruction appears. The words "high voltage" and "low voltage" are relatives and means that the two voltages are generally incompatibles. For example, the "high voltage" in this context can be superior to 100 Volts and the "high voltage drop" can be superior to 100 Volts by microsecond while the "low voltage" is inferior to 15 Volts.

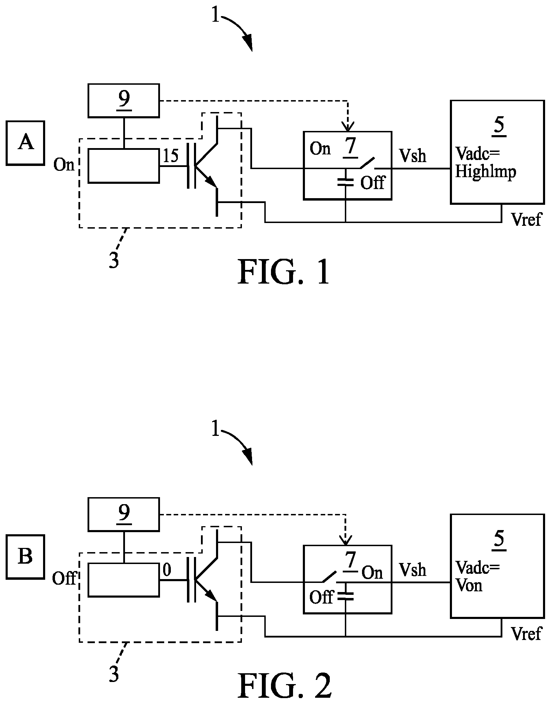

In the embodiment of figures 1 and 2, the module 1 comprises a single high-voltage part 3 and a single acquisition part 5. The acquisition part 5 is electrically disposed such that to be able to measure a voltage of the high-voltage part 3. An intermediate circuit 7 is electrically disposed between the high-voltage part 3 and the acquisition part 5. The intermediate circuit 7 includes at least one capacitance electrically disposed between two switches, or an equivalent sample-and-hold circuit ("S&H").

In the sample state A (see figure 1), the intermediate circuit 7 is electrically disconnected from the acquisition part 5 and electrically connected to the high-voltage part 3. In the acquiring state B (see figure 2), the intermediate circuit 7 is electrically connected to the acquisition part 5 and electrically disconnected from the high-voltage part 3. In the example, to passing from the sample state A to the acquiring state B and *vice versa,* the S&H circuit of the intermediate circuit 7 comprises a pair of switches. The first switch is disposed at the input side (or upstream side) of the intermediate circuit 7 near to the high-voltage part 3, while the second switch is disposed at the output side (or downstream side) of the intermediate circuit 7 near to the acquisition part 5. In the sample state A, the first switch is closed ("on" on figure 1) and the second switch is open ("off' on figure 1). In the acquisition state B, the first switch is open ("off' on figure 2) and the second switch is close ("on" on figure 2).

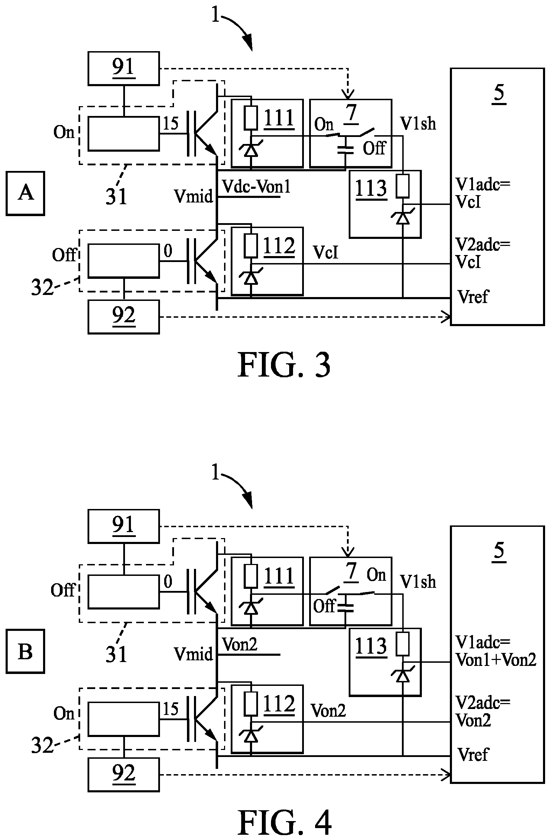

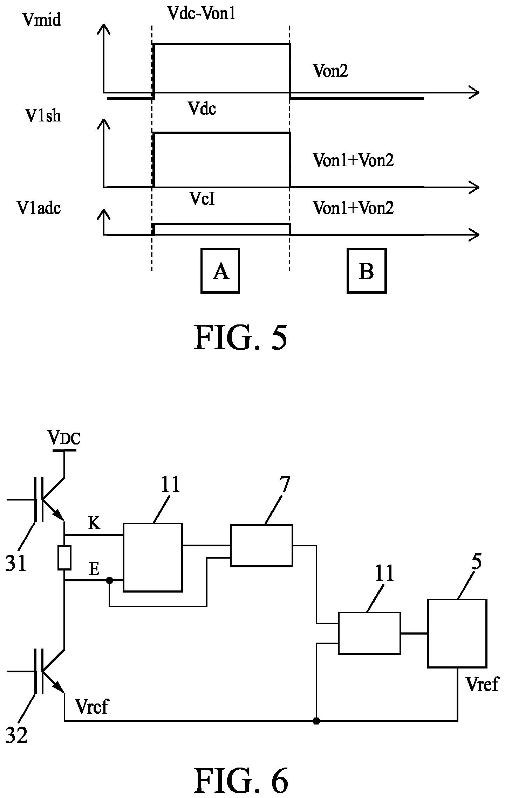

In the examples, the S&H circuit of the intermediate circuit 7 further includes at least one capacitance. A terminal of the capacitance is electrically disposed between the two switches. When the module 1 is in the sample state A, an input voltage Vₒₙ issued from the high-voltage part 3 is sampled and hold in the capacitance. Then, when the module 1 is in the acquisition state B, the sampled hold voltage, referenced Vₛₕ, is released toward the acquisition part 5 to be acquired. In the examples, the output of the intermediate circuit 7 is arranged to limit the voltage output to a non-destructive voltage for the acquisition part 5. For example, an high impedance is provided. In some embodiments, the S&H circuit includes high-voltage power components. Alternatively, at least a clamp circuit with high-voltage power components is used as it will be described hereinafter with figures 4 and 5. To combine S&H circuit and clamp circuit allow using cheap and classical S&H circuits. For example, a commercially available device like the device referenced "LF3978" of Texas Instruments can be used.

The objective of the sample and hold (S&H) function is to capture an on-state voltage and store it until it is acquired by the acquisition part 5, for example in the same switching period. Functionally, a S&H circuit can be simplified with 2 switches and a capacitor (as represented on the figures). However, another implementation can comprises a dedicated integrated circuit which implementation may differ from this simplified representation. In the sample mode (during the sample state A), a first switch (downstream side) is on (closed) and allows charging the capacitor to a value equal to the input voltage. In the hold mode, both switches are off (open), the potential across the capacitor is stored. In the transmit mode (during the acquiring state B), the second switch (upstream side) is on (closed) to connect the capacitor voltage to an acquisition means (the acquisition part 5 in the examples). For example, commercially-available devices, such as the device referenced "LF398" from Texas Instruments, can be used to ensure this function.

On the example of figures 1 and 2, the acquisition part 5 comprises a single input channel. The voltage received on the input channel is referenced V_{adc}. During the sample state A, the received voltage V_{adc} is substantially undefined or equal to a reference voltage (considered equal to zero by default). During the acquisition state B, the received voltage V_{adc} is substantially equal to the sampled and hold voltage Vₛₕ (V_{adc} = Vₛₕ).

In the following examples, the voltage acquisition is performed with an Analog-to-Digital Converter (ADC). For example, a low-cost 12-bit SAR ADC (SAR for *"Successive Approximation Register*") may be sufficient to obtain the accuracy, precision, drift and stability requirements. The requirements on the voltage supply used by the ADC may be high to make sure the accuracy, precision, drift and stability requirements are ensured. In the example of figure 2, the acquisition is performed when the second (upstream) switch of the intermediate circuit 7 is "On". For example, a signal can be derived from the control part 9 or from the intermediate circuit 7 to trigger the acquisition. Alternatively, the voltage is constantly acquired but only transmitted when the acquired value is within a predefined range of values.

To control the state (A or B) of the module 1, the intermediate circuit 7 and especially the S&H circuit is controlled by a control part, referenced 9 on figures 1 and 2. The control part 9 is arranged to control the states changing of the intermediate circuit 7. In the examples, the control part 9 is arranged in such a way to command the intermediate circuit 7 at least in function of a state of the high-voltage part 3. In other words, the control part 9 received, as an input signal, state information of the high-voltage part 3.

The control part 9 includes an on-state detector. In an example of implementation, the on-state detector is the gate driver output of the semiconductor device itself (in case of IGBT). Thus it is already referenced to an appropriate voltage reference value. A scale-down circuit may be used to modify the output from, for example, -15V/+15V to 0V/5V logic. In such an example, the off-state detector can be the gate-driver of the complementary switch.

In case of electrical conduction of a body-diode, the gate driver may not reflect the on-state. The clamped value of Vₒₙ may be compared to a threshold value of, for example 3 Volts, to determine if the device is "off' (clamp limit) or "on" (Vₒₙ lower than the clamp limit).

The control part 9 is arranged to trigger the sample state A when the high-voltage part 3 is active (under voltage; state "On") and to trigger the acquisition state B when the high-voltage part 3 is inactive (at rest; state "Off').

In some embodiments, the control part 9 is further arranged to provide a delaying time function such that emission of output control signals toward the intermediate circuit 7 can be delayed with respect to reception of input information signals. In other words, the triggering of state A, B changing is voluntarily not immediate when a change of state of the high-voltage part 3 is detected. The objective of the delay is to make sure the measurement/acquisition is performed a time sufficiently long after the switch transition to reduce the noise. The delay can be made with an active circuit, a passive circuit, or a combination of both active and passive circuits. The delay is, in most cases, few microseconds.

In various embodiments, the module 1 further comprises a clamp circuit. The clamp circuit is electrically disposed between the high-voltage part 3 and the intermediate circuit 7 and/or between the intermediate circuit 7 and the acquisition part 5. In the following examples the clamp circuit is distinct (external) from the S&H circuit. This enables to protect the measurement circuit (the acquisition part 5) from high voltages. For example, the clamp circuit is composed of a current-limiting resistor and of at least a diode, or a Zener diode, for clamping the voltage to a predetermined threshold value. For example the resistor is about 10 mega ohms. An example of a threshold voltage is 4 volts.

In various embodiments, such as the one illustrated on figure 1, the clamp circuit is composed of at least one high-voltage switch (able to withstand the bus voltage V_{dc}), and the voltage protection is performed with the said switch. Some clamp circuits and there functions will be described in more details with respect to figures 3 and 4.

The embodiment of figures 3 and 4 will now be described. On these figures, the module 1 comprises two high-voltage parts 31, 32, and a single common acquisition part 5. The two high-voltage parts 31, 32 are connected in series. The voltage between them (with respect to a non-represented reference) is referenced V_{mid}. The acquisition part 5 is electrically disposed such that to be able to measure voltages of both first high-voltage part 31 and second high-voltage part 32. The module 1 comprises a single intermediate circuit 7 electrically disposed between the first high-voltage parts 31 and the acquisition part 5. In the example, the intermediate circuit 7 is similar to the one of figures 1 and 2 and includes a sample-and-hold circuit ("S&H").

The acquisition part 5 includes two input channels such that to acquire two distinct voltages measures. In various embodiments, the acquisition part 5 can comprise more than two channels, for example when the module 1 comprises more than two high-voltage parts.

In the embodiment of figures 3 and 4, the module 1 further comprises three clamp circuits 111, 112, 113. The first clamp circuit 111 is electrically disposed between the first high-voltage part 31 and the intermediate circuit 7, such that to clamp the voltage issued from the first high-voltage part 31 before to be sampled and hold by the intermediate circuit 7. The second clamp circuit 112 is electrically disposed between the second high-voltage part 32 and a second input V_{2adc} of the acquisition part 5, such that to clamp the voltage issued from the second high-voltage part 32 before to be measured/acquired by the acquisition part 5. The third clamp circuit 113 is electrically disposed between the intermediate circuit 7 and a first channel V_{1adc} of the acquisition part 5, such that to clamp the voltage between the output V₁ₛₕ of the intermediate circuit 7 and the output of the second clamp circuit 112. The output of the third clamp circuit 113 is connected to the first channel V_{1adc} of the acquisition part 5.

Figure 3 shows the situation in the sample state A: when the first high-voltage part 31 is active (under voltage; state "On") and the second high-voltage part 32 is inactive (at rest; state "Off"). Figure 4 shows the situation in the acquisition state B which is inversed with respect to the sample state A: when the first high-voltage part 31 is inactive (at rest; state "Off") and the second high-voltage part 32 is active (under voltage; state "On"). Figure 5 shows some voltage values in the module 1 during the two states A and B.

During the sample state A, the voltage Vₒₙ₁ at the output of the first high-voltage part 31 the clamp is deactivated since Vₒₙ₁ is below its threshold value, and Vₒₙ₁ is sampled and then hold on the intermediate circuit 7. The downstream part of the intermediate circuit 7 is disconnected from the impedance. As a consequence, for example, the voltage V₁ₛₕ₋V_{ref} at the output of the intermediate circuit 7 is equal to zero and the voltage V₁ₛₕ is equal to the voltage of the mid-point V_{mid}. The measured voltage on the first channel V_{1adc} of the acquisition part 5, at the output of the third clamp circuit 113, is thus equal to the clamped voltage V_{cl}.

The voltage at the output of the second high-voltage part 32 is substantially V_{mid}. At the output of the second clamp circuit 112 and on the second channel V_{2adc} of the acquisition part 5, the voltage is thus also equal to the clamped voltage V_{cl}.

The voltage V_{mid}, between the two high-voltage parts 31, 32, is equal to the sum of a bus voltage V_{dc} and the opposite to the voltage Vₒₙ₁ at the output of the first high-voltage part 31 (V_{mid} = V_{dc} - Vₒₙ₁).

During the acquisition state B, the upstream part of the intermediate circuit 7 is disconnected from the high voltage part 31. The sample and hold circuit discharges the sampled and hold voltage Vₒₙ₁ towards the inactive third clamp circuit 113.

The voltage issued from the second high-voltage part 32 is not V_{mid} (referenced Vₒₙ₂). The second clamp circuit 112 is deactivated. As a consequence, the measured voltage on the second channel V_{2adc} of the acquisition part 5 is thus equal to Vₒₙ₂. The voltage V_{mid}, between the two high-voltage parts 31, 32, in the acquisition state B, is equal to the voltage issued from the second high-voltage part 32: Vₒₙ₂. The voltage _{V1sh} at the output of the intermediate circuit 7 is equal to the sum of the discharging voltage Vₒₙ₁ and the voltage Vₒₙ₂ issued from the second high-voltage part 32 (_{V1sh} = Vₒₙ₁ + Vₒₙ₂). This sum is not altered by the clamping of the third clamp circuit 113 and is thus acquired on the first channel V_{1adc} of the acquisition part 5.

In the embodiment of figures 3 and 4, the module 1 comprises two control parts 91, 92. The first control part 91 is arranged to control the states changing of the intermediate circuit 7, for example similarly to the embodiment of figures 1 and 2. The second control part 92 is arranged to trigger the acquisition of a voltage (Vₒₙ₂) on the second channel V_{2adc} when the second high-voltage part 32 is active (under voltage; state "On"). The second control part 92 is further arranged to provide a delaying time function such that delaying the acquisition with respect to detection of the active state of the second control part 92. The objective of the delay is to make sure the measurement/acquisition is performed a time sufficiently long after the switch transition to reduce the noise during the acquisition. The delay can be made with an active circuit, a passive circuit, or a combination of both active and passive circuits. The delay is, in most cases, few microseconds.

On the figures, the high-voltage parts 3, 31, 32 are represented only by a symbol of an IGBT. The represented circuit can also be used to acquire/measure Vₒₙ, Vₒₙ₁, Vₒₙ₂ of the corresponding anti-parallel diode, the current sign being reversed.

In the embodiment of figures 3 and 4, the second channel V_{2adc} enables measuring the voltage Vₒₙ₂ of the second high-voltage part 32 (during the acquisition step B). The first channel V_{1adc} enables measuring the sum Vₒₙ₁ + Vₒₙ₂ of the voltages of the first and second high-voltage parts 31, 32 (during the acquisition step B). A simple subtraction enables to obtain the voltage Vₒₙ₁ of the first high-voltage part 31 (previously sampled and hold on the intermediate circuit 7 during the sample step A).

The first clamp circuit 111 enables protecting the S&H circuit of the intermediate circuit 7. The second clamp circuit 112 enables protecting the second channel V_{2adc} of the acquisition part 5. The third clamp circuit 113 enables protecting the first channel V_{1adc} of the acquisition part 5.

Figure 6 represents an example of an embodiment of a module where the measured voltage Vₒₙ is the voltage between a Kelvin emitter (referenced "K") and a Power emitter (referenced "E") and including a portion of the electrical connection symbolically represented by a resistance (a rectangular shape).

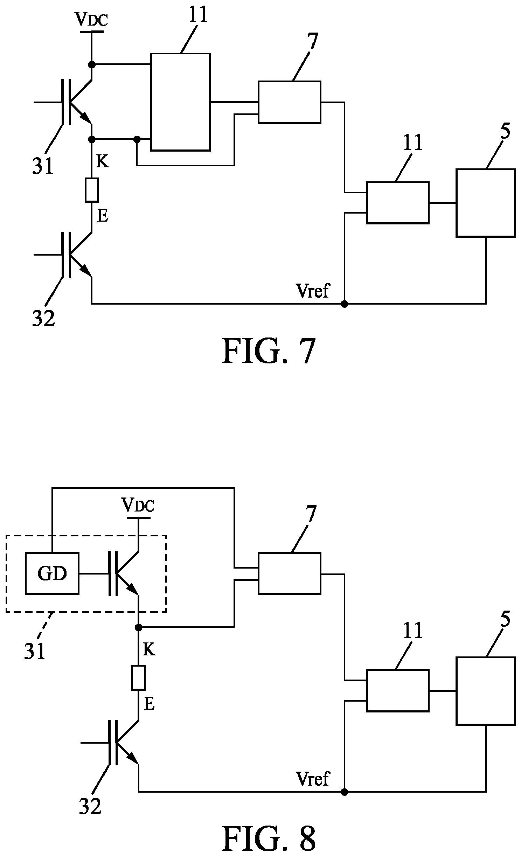

Figure 7 represents an example of an embodiment of a module where the measured voltage Vₒₙ is the voltage between a collector (corresponding to the connection to the bus voltage V_{dc}) and a kelvin emitter (referenced "K") and excluding a portion of the electrical connection symbolically represented by a resistance (a rectangular shape).

Figure 8 represents an example of an embodiment of a module where the measured voltage Vₒₙ is the voltage between a gate (referenced "GD") and a kelvin emitter (referenced "K") and excluding a portion of the electrical connection symbolically represented by a resistance (a rectangular shape).

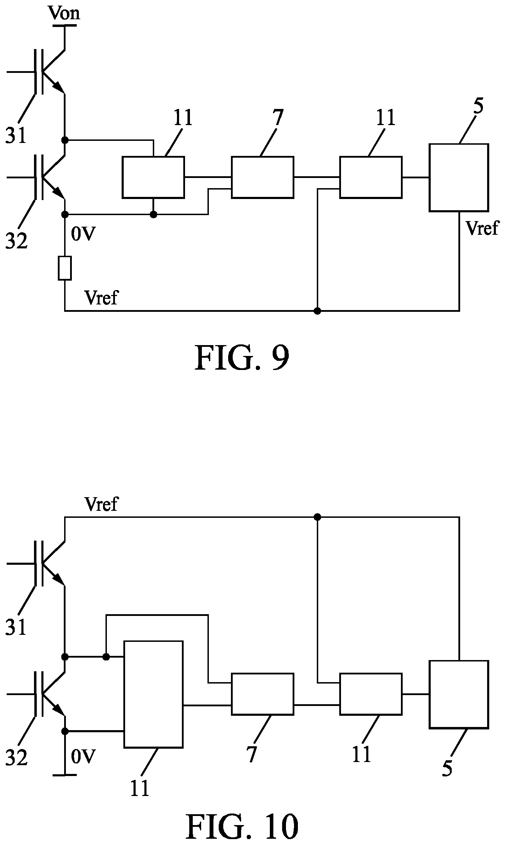

Figures 9 and 10 represents circuit topologies wherein the method of measurements is particularly advantageous. The modules comprise power semi-conductor switches.

If the reference voltage (reference for a main acquisition part) is connected to a low-side switch, the proposed solution can be used to monitor the high-side switch. In the example of figure 9, the proposed solution is used on the low-side switch because it is loosely connected to the reference voltage. The low-side is measured because the reference voltage is loosely connected to the "0 volt". In various embodiments, the proposed solution can also be used if a voltage drop may exist between the low-side switch and the reference voltage when the low-side switch is conducting.

In some cases, represented on figure 10, the reference voltage may be connected to the high-side switch or to both the low-side and high-side switch. In these cases, the invention may apply to the low-side switch or to both switches. On the example of figure 10, the reference voltage is connected to the high-side switch. Thus, the low-side is measured.

In the previous examples, the S&H circuit and the clamp circuits are presented as distinct electrical components. Doing this, a low-cost S&H circuit can be used, including an existing model one. In the previous examples, the voltages are captured when a switch is "on" (closed) and transmitted to be acquired when it is "Off" (closed), without needs of costly electrical isolation equipment/component. The modules 1 above described are deprived from analog isolator and digital isolator between the high-voltage part(s) and the acquisition part(s).

The operations above described can be implemented on the same period of time, in two successive sample state A and acquisition sate B. The said operations can be repeated, for example to ensure a substantially continuous monitoring of the voltages.

Some examples of various embodiments have been above described with reference to specific configuration of modules 1 including one power semi-conductor switch (for example embodiments of figures 1 and 2) or including a plurality of power semi-conductor switches (for example embodiments of figures 3 to 5). In another aspect, the invention can be view as a method to sense voltages into such modules.

For example, it is possible to improve the following method:
a) detect an on-state of at least one of said power semi-conductor switches;
b) after said on-state detection, sample and hold a voltage of at least one of said power semi-conductor switches;
c) detect an off-state of at least one of said power semi-conductor switches;
d) after said off-state detection, transmit said hold voltage to an acquisition part of said module.

In the above steps a) to d), the words *"at least one of said power semi-conductor switches"* can designate always the same power semi-conductor switch in each step, for example in a configuration corresponding to the example of figures 1 and 2 with a single power switch.

In various embodiments, depending on the configuration of the module, these words can designate distinct power semi-conductor switches in function of the steps. For example, the on-state of a first switch can be detected (step a), and then, the voltage of a second switch can be sampled and hold (step b). Particularly in configuration comprising a plurality of power switches, this enables to detect the state of a single power switch (with a single equipment/component) while acquiring the voltages of distinct parts of the module.

In some embodiments, a delaying step can be added between steps a and b, which means waiting a "blanking time" before to sample the voltage. This enables to reduce the measured noise due to the switching operations.

As previously indicated, detecting an on-state and/or an off-state of a power semi-conductor switch can be indirect, for example by detecting the state of another power semi-conductor switch if the states of the two power switches are coupled and known.

As previously described with respect to figures 3 and 4 for example, the method can further comprise acquisition of at least one supplementary voltage (Vₒₙ₂) with respect to the sampled and hold voltage (Vₒₙ₁).

The invention is not limited to the modules/devices and to the methods described here, which are only examples. The invention encompasses every alternative falling under the scope of the claims that a person skilled in the art would envisage when reading the present text.

## Claims

1. Power semi-conductor module (1) comprising:
- an high-voltage part (3, 31, 32) arranged to operate at high-voltage and including a power semi-conductor switch;
- an acquisition part (5) arranged to acquire measurements from the high-voltage part (3) and to operate at a low voltage incompatible with said high-voltage;
- an intermediate circuit (7), electrically disposed between said power semi-conductor switch of the high-voltage part (3, 31, 32) and the acquisition part (5); and
- a control part (9, 91, 92),
said intermediate circuit (7) having the at least two following states:
- a sample state (A) wherein said intermediate circuit (7) is electrically disconnected from the acquisition part (5) and electrically connected to said power semi-conductor switch of the high-voltage part (3, 31, 32) such that a voltage sample (Vₒₙ, Vₒₙ₁, Vₒₙ₂) of the operating high-voltage is stored on said intermediate circuit (7);
- an acquiring state (B) wherein said intermediate circuit (7) is electrically disconnected from said power semi-conductor switch of the high-voltage part (3, 31, 32) and electrically connected to the acquisition part (5) such that a voltage sample (Vₒₙ, Vₒₙ₁, Vₒₙ₂) previously stored on said intermediate circuit (7) is discharged to the acquisition part (5),
the control part (9, 91) being arranged to control the states changing of the intermediate circuit (7).

2. Module (1) according to claim 1, wherein the module (1) has no analog isolator or digital isolator between said high-voltage part (3, 31, 32) and said acquisition part (5).

3. Module (1) according to one the preceding claims, wherein the module (1) comprises at least two high-voltage parts (31, 32) arranged to operate at high-voltage, said acquisition part (5) being arranged to acquire measurements from both high-voltage parts (31, 32).

4. Module (1) according to claim 3, wherein said acquisition part (5) includes at least two input channels to acquire two distinct voltage measurements.

5. Module (1) according to one the preceding claims, wherein said intermediate circuit (7) includes two switches and at least one capacitance electrically disposed between the two switches, or a sample-and-hold circuit, each switch being controlled by said control part (9, 91, 92), the states of the switches defining said sample state (A) and acquiring state (B) of the module (1).

6. Module (1) according to one the preceding claims, further comprising at least one clamp circuit (111, 112, 113) electrically disposed between said high-voltage part (31, 32) and said intermediate circuit (7), and/or between said intermediate circuit (7) and said acquisition part (5).

7. Module (1) according to one the preceding claims, wherein said control part (9, 91, 92) is arranged in such a way to command said intermediate circuit (7) at least in function of a state of said high-voltage part (3, 31, 32).

8. Module (1) according to one the preceding claims, wherein said control part (9, 91, 92) is arranged to provide a delaying time function such that emission of output control signals can be delayed with respect to reception of input information signals.

9. Method for sensing a voltage of at least one power semi-conductor switch in a module (1) including one or more power semi-conductor switches (3, 31 32), the method comprising:
a) detect an on-state of at least one of said power semi-conductor switches (3, 31);
b) after said on-state detection, sample and hold a voltage of at least one of said power semi-conductor switches (3, 31);
c) detect an off-state of at least one of said power semi-conductor switches (3, 31);
d) after said off-state detection, transmit said held voltage (Vₒₙ, Vₒₙ₁) to an acquisition part (5) of said module (1).

10. Method according to claim 9, further comprising the following step after said step a) and before said step b):
a') delaying the implementation of said step b) during a predetermined buffer time.

11. Method according to one of claims 9 and 10, wherein said step c) of detecting an off-state of at least one of said power semi-conductor switches (3, 31) includes detecting an on-state of another one of said power semi-conductor switches (32) of said module (1) such that the off-state detection is indirect.

12. Method according to one of claims 9 to 11, further comprising:
e) after said off-state detection of said step c), acquiring a voltage (Vₒₙ₂) by said acquisition part (5) of said module (1) of at least one (32) of said power semi-conductor switches distinct from the power semi-conductor switch (31) of which the voltage has been sampled and hold in step b).

## Patentansprüche

1. Leistungshalbleitermodul (1), welches aufweist:
- ein Hochspannungsteil (3, 31, 32), das angeordnet ist, um bei hoher Spannung zu arbeiten, und das einen Leistungshalbleiterschalter enthält;
- ein Erfassungsteil (5), das angeordnet ist, um Messungen von dem Hochspannungsteil (3) zu erfassen und bei einer niedrigen Spannung zu arbeiten, die mit der hohen Spannung inkompatibel ist;
- eine Zwischenschaltung (7), die elektrisch zwischen dem Leistungshalbleiterschalter des Hochspannungsteils (3, 31, 32) und dem Erfassungsteil (5) angeordnet ist; und
- ein Steuerteil (9, 91, 92),
wobei die Zwischenschaltung (7) die zumindest zwei folgenden Zustände aufweist:
- einen Abtastzustand (A), in dem die Zwischenschaltung (7) von dem Erfassungsteil (5) elektrisch getrennt ist und mit dem Leistungshalbleiterschalter des Hochspannungsteils (3, 31, 32) elektrisch verbunden ist, so dass eine Spannungsabtastung (Vₒₙ, Vₒₙ₁, Vₒₙ₂) der arbeitenden hohen Spannung an der Zwischenschaltung (7) gespeichert wird;
- einen Erfassungszustand (B), in dem die Zwischenschaltung (7) von dem Leistungshalbleiterschalter des Hochspannungsteils (3, 31, 32) elektrisch getrennt ist und mit dem Erfassungsteil (5) elektrisch verbunden ist, so dass eine zuvor an der Zwischenschaltung (7) gespeicherten Spannungsabtastung (Vₒₙ, Vₒₙ₁, Vₒₙ₂) an das Erfassungsteil (5) entladen wird,
wobei das Steuerteil (9, 91) angeordnet ist, um die die Zwischenschaltung (7) ändernden Zustände zu steuern.

2. Modul (1) nach Anspruch 1, wobei das Modul (1) keinen analogen Isolator oder digitalen Isolator zwischen dem Hochspannungsteil (3, 31, 32) und dem Erfassungsteil (5) aufweist.

3. Modul (1) nach einem der vorhergehenden Ansprüche, wobei das Modul (1) zumindest zwei Hochspannungsteile (31, 32) aufweist, die angeordnet sind, um bei hoher Spannung zu arbeiten, wobei das Erfassungsteil (5) angeordnet ist, um Messungen von beiden Hochspannungsteilen (31, 32) zu erfassen.

4. Modul (1) nach Anspruch 3, wobei das Erfassungsteil (5) zumindest zwei Eingangskanäle enthält, um zwei unterschiedliche Spannungsmessungen zu erfassen.

5. Modul (1) nach einem der vorhergehenden Ansprüche, wobei die Zwischenschaltung (7) zwei Schalter und zumindest einen Kondensator enthält, der elektrisch zwischen den zwei Schaltern angeordnet ist, oder eine Abtast-und-Halte-Schaltung, wobei der Schalter von dem Steuerteil (9, 91, 92) gesteuert wird, wobei die Zustände der Schalter den Abtastzustand (A) und den Erfassungszustand (B) des Moduls (1) definieren.

6. Modul (1) nach einem der vorhergehenden Ansprüche, das ferner zumindest eine Blockierschaltung (111, 112, 113) aufweist, die elektrisch zwischen dem Hochspannungsteil (31, 32) und der Zwischenschaltung (7) und/oder zwischen der Zwischenschaltung (7) und dem Erfassungsteil (5) angeordnet ist.

7. Modul (1) nach einem der vorhergehenden Ansprüche, wobei das Steuerteil (9, 91, 92) derart angeordnet ist, um die Zwischenschaltung (7) zumindest in Funktion eines Zustands des Hochspannungsteils (3, 31, 32) anzuweisen.

8. Modul (1) nach einem der vorhergehenden Ansprüche, wobei das Steuerteil (9, 91, 92) angeordnet ist, um eine Verzögerungszeitfunktion vorzusehen, so dass die Ausgabe von Ausgangssteuersignalen in Bezug auf den Empfang von Eingangsinformationssignalen verzögert werden kann.

9. Verfahren zum Sensieren einer Spannung von zumindest einem Leistungshalbleiterschalter in einem Modul (1), das einen oder mehrere Leistungshalbleiterschalter (3, 31, 32) enthält, wobei das Verfahren aufweist:
a) Detektieren eines EIN-Zustands von zumindest einem der Leistungshalbleiterschalter (3, 31);
b) nach der EIN-Zustand-Detektion, Abtasten und Halten einer Spannung von zumindest einem der Leistungshalbleiterschalter (3, 31);
c) Detektieren eines AUS-Zustands von zumindest einem der Leistungshalbleiterschalter (3, 31);
d) nach der AUS-Zustand-Detektion, Senden der gehaltenen Spannung (Vₒₙ, Vₒₙ₁) zu einem Erfassungsteil (5) des Moduls (1).

10. Verfahren nach Anspruch 9, das ferner, nach dem Schritt a) und vor dem Schritt b), den folgenden Schritt aufweist:
a') Verzögern der Implementierung des Schritts b) während einer vorbestimmten Pufferzeit.

11. Verfahren nach einem der Ansprüche 9 und 10, wobei der Schritt c) zum Detektieren eines AUS-Zustands von zumindest einem der Leistungshalbleiterschalter (3, 31) enthält, einen EIN-Zustand eines anderen der Leistungshalbleiterschalter (32) des Moduls (1) zu detektieren, so dass die AUS-Zustand-Detektion indirekt ist.

12. Verfahren nach einem der Ansprüche 9 bis 11, das ferner aufweist:
e) nach der AUS-Zustand-Detektion von Schritt c), Erfassen einer Spannung (Vₒₙ₂) mit dem Erfassungsteil (5) des Moduls (1) von zumindest einem (32) der Leistungshalbleiterschalter, der sich von dem Leistungshalbleiterschalter (31) unterscheidet, dessen Spannung in Schritt b) abgetastet und gehalten worden ist.

## Revendications

1. Module de puissance à semi-conducteur (1) comprenant :
- une partie haute tension (3, 31, 32) agencée pour fonctionner à haute tension et incluant un commutateur de puissance à semi-conducteur ;
- une partie acquisition (5) agencée pour acquérir des mesures provenant de la partie haute tension (3) et pour fonctionner à une basse tension incompatible avec ladite haute tension ;
- un circuit intermédiaire (7), disposé électriquement entre ledit commutateur de puissance à semi-conducteur de la partie haute tension (3, 31, 32) et la partie acquisition (5) ; et
- une partie commande (9, 91, 92),
ledit circuit intermédiaire (7) présentant les au moins deux états suivants :
- un état d'échantillonnage (A) dans lequel ledit circuit intermédiaire (7) est électriquement déconnecté de la partie acquisition (5) et connecté électriquement audit commutateur de puissance à semi-conducteur de la partie haute tension (3, 31, 32) de façon qu'un échantillon de tension (Vₒₙ, Vₒₙ₁, Vₒₙ₂) de la haute tension de fonctionnement soit stocké sur ledit circuit intermédiaire (7) ;
- un état d'acquisition (B) dans lequel ledit circuit intermédiaire (7) est électriquement déconnecté dudit commutateur de puissance à semi-conducteur de la partie haute tension (3, 31, 32) et connecté électriquement à la partie acquisition (5) de façon qu'un échantillon de tension (Vₒₙ, Vₒₙ₁, Vₒₙ₂) précédemment stocké sur ledit circuit intermédiaire (7) soit déchargé vers la partie acquisition (5),
la partie commande (9, 91) étant agencée pour commander les changements d'états du circuit intermédiaire (7).

2. Module (1) selon la revendication 1, dans lequel le module (1) n'a pas d'isolateur analogique ou d'isolateur numérique entre ladite partie haute tension (3, 31, 32) et ladite partie acquisition (5).

3. Module (1) selon l'une des revendications précédentes, dans lequel le module (1) comprend au moins deux parties haute tension (31, 32) agencées pour fonctionner à haute tension, ladite partie acquisition (5) étant agencée pour acquérir des mesures provenant des deux parties haute tension (31, 32).

4. Module (1) selon la revendication 3, dans lequel ladite partie acquisition (5) inclut au moins deux canaux d'entrée pour acquérir deux mesures de tension distinctes.

5. Module (1) selon l'une des revendications précédentes, dans lequel ledit circuit intermédiaire (7) inclut deux commutateurs et au moins une capacité disposée électriquement entre les deux commutateurs, ou un échantillonneur-bloqueur, chaque commutateur étant commandé par ladite partie commande (9, 91, 92), les états des commutateurs définissant lesdits état d'échantillonnage (A) et état d'acquisition (B) du module (1).

6. Module (1) selon l'une des revendications précédentes, comprenant en outre au moins un circuit de verrouillage (111, 112, 113) disposé électriquement entre ladite partie haute tension (31, 32) et ledit circuit intermédiaire (7), et/ou entre ledit circuit intermédiaire (7) et ladite partie acquisition (5).

7. Module (1) selon l'une des revendications précédentes, dans lequel ladite partie commande (9, 91, 92) est agencée de manière à commander ledit circuit intermédiaire (7) au moins en fonction d'un état de ladite partie haute tension (3, 31, 32).

8. Module (1) selon l'une des revendications précédentes, dans lequel ladite partie commande (9, 91, 92) est agencée pour fournir une fonction de temps de retard telle que l'émission de signaux de commande de sortie puisse être retardée par rapport à la réception de signaux d'information d'entrée.

9. Procédé de détection d'une tension d'au moins un commutateur de puissance à semi-conducteur dans un module (1) incluant un ou plusieurs commutateurs de puissance à semi-conducteur (3, 31 32), le procédé comprenant :
a) la détection d'un état passant d'au moins l'un desdits commutateurs de puissance à semi-conducteur (3, 31) ;
b) après ladite détection de l'état passant, l'échantillonnage et la conservation d'une tension d'au moins l'un desdits commutateurs de puissance à semi-conducteur (3, 31) ;
c) la détection d'un état bloqué d'au moins l'un desdits commutateurs de puissance à semi-conducteur (3, 31) ;
d) après ladite détection de l'état bloqué, la transmission de ladite tension conservée (Vₒₙ, Vₒₙ₁) à une partie acquisition (5) dudit module (1).

10. Procédé selon la revendication 9, comprenant en outre l'étape suivante après ladite étape a) et avant ladite étape b) :
a') le report de la mise en œuvre de ladite étape b) pendant un temps tampon prédéterminé.

11. Procédé selon l'une des revendications 9 et 10, dans lequel ladite étape c) de détection d'un état bloqué d'au moins l'un desdits commutateurs de puissance à semi-conducteur (3, 31) inclut la détection d'un état passant d'un autre desdits commutateurs de puissance à semi-conducteur (32) dudit module (1) de sorte que la détection d'un état bloqué est indirecte.

12. Procédé selon l'une des revendications 9 à 11, comprenant en outre :
e) après ladite détection de l'état bloqué de ladite étape c), l'acquisition d'une tension (Vₒₙ₂) par ladite partie acquisition (5) dudit module (1) d'au moins l'un (32) desdits commutateurs de puissance à semi-conducteur distincts du commutateur de puissance à semi-conducteur (31) dont la tension a été échantillonnée et conservée dans l'étape b).
